Europäisches Patentamt

European Patent Office

Office européen des brevets

(11) Publication number: **0 185 572 B1**

## EUROPEAN PATENT SPECIFICATION

(45) Date of publication of patent specification: **03.04.91**    (51) Int. Cl.⁵: **G11C 8/00**, G11C 7/06

(21) Application number: **85402247.2**

(22) Date of filing: **20.11.85**

(54) Semiconductor memory with bit lines divided into blocks.

(30) Priority: **20.11.84 JP 245801/84**
**20.11.84 JP 245803/84**

(43) Date of publication of application:
**25.06.86 Bulletin 86/26**

(45) Publication of the grant of the patent:
**03.04.91 Bulletin 91/14**

(84) Designated Contracting States:
**DE FR GB**

(56) References cited:
**EP-A- 0 068 645**
**US-A- 4 122 546**

**IBM TECHNICAL DISCLOSURE BULLETIN, vol.
22, no. 8B, January 1980, pages 3738,3739,
New York, US; L. ARZUBI et al.: "Bit line
cascading in semiconductor storage chips"**

**PATENT ABSTRACTS OF JAPAN, vol. 6, no.
62 (P-111)[940], 21st April 1982; & JP-A-57
3290 (NIPPON DENKI K.K.) 08-01-1982**

(73) Proprietor: **FUJITSU LIMITED**
**1015, Kamikodanaka Nakahara-ku
Kawasaki-shi Kanagawa 211(JP)**

(72) Inventor: **Aoyama, Keizo**
**11-28, Tsukimino 1 chome
Yamato-shi Kanagawa 242(JP)**

(74) Representative: **Descourtieux, Philippe et al
CABINET BEAU de LOMENIE 55 rue
d'Amsterdam
F-75008 Paris(FR)**

**Description**

The present invention relates to a semiconductor memory device having a plurality of memory cells arranged in a matrix formed by word lines and bit lines connected to a data bus, and more particularly to a semiconductor memory device wherein the bit lines are divided into a plurality of blocks each including a plurality of memory cells, a sense amplifier and a switching element inserted into each bit line.

Memory devices having a still larger memory capacity are proposed, with the result that the number of memory cells increases considerably with many word lines and bit lines connected to the memory cells. Accordingly, the stray capacitance distributed along the word and bit lines increases, which lowers the operation speed of the memory device.

In order to solve this problem, it has been proposed to divide the bit lines or, more usually, the pairs of bit lines into a plurality of blocks, as disclosed in the Japanese Laid-Open Patent Application No. 84-101093. Each block includes a plurality of memory cells, a sense amplifier and a switching element inserted into each bit line. Means are provided which are responsive to the selection of a memory cell to be accessed ·for activating only the sense amplifier of the block containing the selected memory cell. The switching elements are controlled after activation of the sense amplifier of the selected block (i.e. the block containing the selected memory cell) to make ON only the switching elements of the selected block and of each other block eventually located between the selected block and the data bus.

The object of the invention is to improve such semiconductor memory devices by allowing a high operation speed while reducing the power consumption.

Another object of the invention is also to increase the operation reliability of the semiconductor memory device.

The above objects are achieved according to the invention by providing sense amplifiers having respective driving abilities which are different from each other and which increase as the distance between the corresponding blocks and the data bus increases.

Thus, the sense amplifiers in the farthest blocks from the data bus have the highest driving ability to amplify the voltage difference in enough short time despite the load capacitance along the bit lines, while the nearest blocks from the data bus have the lowest driving ability to avoid unnecessary power consumption.

Sense amplifiers having different driving abilities can be obtained by using MOS (metal-oxide-semiconductor) transistors having different channel sizes.

The particulars and advantages of the invention will become more readily apparent from the following description made with reference to the accompanying drawings wherein:

FIG.1 is a circuit diagram of a prior art memory device with non divided bit lines;

FIG.2 is a circuit diagram of a column part of a prior art memory device divided into blocks;

FIG.3(a) is a circuit diagram of a conventional precharge circuit which can be used in connection with a block of a column part of the memory device of Fig.2 or of the memory device according to the invention;

FIG.3(b) and 3(c) are circuit diagrams of two conventional switching elements which can be used in a block of a column part of the memory device of Fig.2 or of the memory device according to the invention;

FIG.4 is a circuit diagram of a column part of a memory device according to the present invention;

FIG.5 is a circuit diagram of a modified clock signal generator for use in a memory device according to the present invention;

FIG.6 is a circuit diagram of a block sense amplifier in a memory device according to the present invention;

FIG. 7(a) and 7(b) are plan views showing patterns of block sense amplifiers in blocks located respectively far and near of the data bus in a memory device according to the present invention; and

FIG.8 is a time chart for illustrating the operation of a memory device according to the present invention.

A description of semiconductor memory devices according to the prior art will first be made.

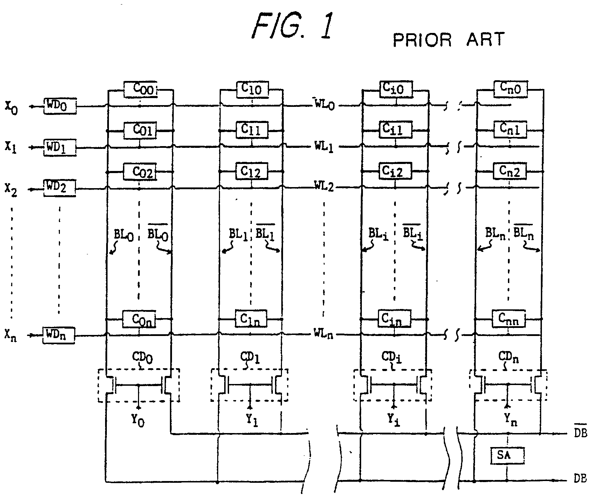

In a conventional memory device having a memory capacity of 64 kilo (K) bits or 256 K bits, the memory cells are arranged in a matrix as shown in Fig.1. In this figure, reference symbols $C_{00}$, $C_{01}$, ---, $C_{0n}$ designate the memory cells in 0-th column; $C_{10}$, $C_{11}$,---, $C_{1n}$ the memory cells in the 1-st column; $C_{i0}$, $C_{i1}$, ---, $C_{in}$ the memory cells in the i-th column; and $C_{n0}$, $C_{n1}$,---, $C_{nn}$ the memory cells in the n-th column. Each memory cell is located at the cross point of respective word line and pair of bit lines. The reference symbols $WD_0$, $WD_1$, ---, and $WD_n$ denote the 0-th, 1-st, ---, and n-th word line, respectively, and $BL_0$, $\overline{BL}_0$; $BL_1$, $\overline{BL}_1$; ---; $BL_i$, $\overline{BL}_i$; ---; $BL_n$, $\overline{BL}_n$ denote the 0-th, 1-st, ---, i-th, ---, and n-th pair of bit lines, respectively. The pairs of bit lines have respective comumn decoders $CD_0$, $CD_1$, ---, $CD_i$, ---, $CD_n$. Similarly, the word lines have respective word decoders $WD_0$, $WD_1$, ---, $WD_n$. When the memory device is in the read mode and word line select signals $X_0$, $X_1$, ---,

and $X_n$ and column select signals $Y_0$, $Y_1$, ---, and $Y_n$ are applied to the word and to the column decoders, a designated memory cell is selected and the data signal stored in the designated memory cell is read out. For example, when the word decoder $WD_i$ and the column decoder $CD_i$ are controlled at the same time by the word line and column select signals $X_i$ and $Y_i'$ respectively, the data signal stored in memory cell $C_{ii}$ is read out and column decoder $CD_i$ operates for sending the read out data signal to a pair of data bus DB, $\overline{DB}$. The read out data sent to the data bus DB, $\overline{DB}$ is amplified by a sense amplifier SA placed in data bus DB and $\overline{DB}$.

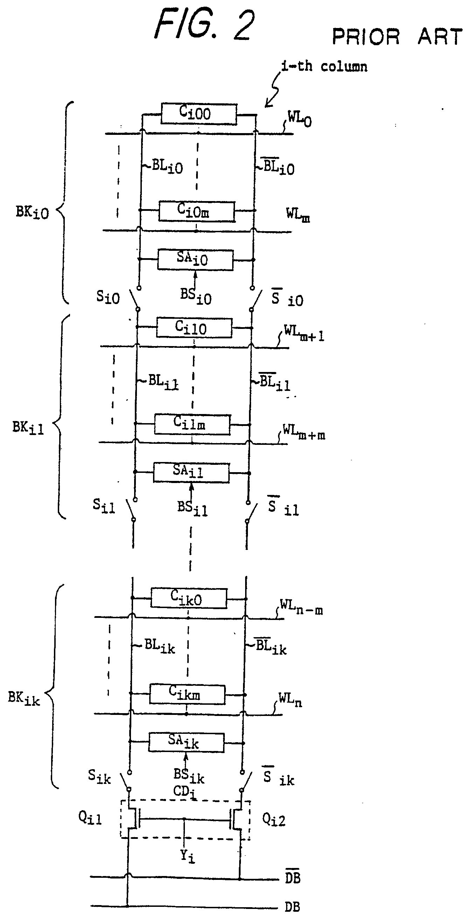

However, when the memory capacity of the memory device increases to reach as much as a mega (M) bits, the number of memory cells also increases, and the stray capacitance distributed along each pair of bit lines increases compared with the memory capacitance provided in each memory cell. Therefore, the operation speed of the memory device for writing a data signal into a memory cell or reading a data signal from the memory cell is lowered; and it becomes difficult to obtain a good signal to noise ratio, which causes a reduction in the operation reliability of the memory device. To solve this problem, it has been proposed to divide each pair of bit lines into a plurality of blocks. Fig. 2 shows a column part of a memory device with the i-th pair of bit lines $BL_i$, $\overline{BL}_i$ divided into k blocks $BK_{i0}$, $BK_{i1}$, ---, and $BK_{ik}$. Each block comprises a pair of divided bit lines, a plurality of memory cells, a block sense amplifier, and a pair of switching elements. For example, block $BK_{ik}$ has a pair of divided bit lines $BL_{ik}$, $\overline{BL}_{ik}$, a plurality of memory cells $C_{ik0}$, $C_{ik1}$, ---, and $C_{ikm}$, a block sense amplifier $SA_{ik}$, and a pair of switching elements $S_{ik}$, $\overline{S}_{ik}$. With reference to the embodiment of Fig.1 where each column has "n" memory cells, the number "m" is such that n = k.m.

In Fig. 2, when one of the memory cells is selected by one of the word select signals, a corresponding one of block select signals $BS_{i0}$, $BS_{i1}$, ---, and $BS_{ik}$ is applied to the block sense amplifier of the block containing the selected memory cell in order to activate said block amplifier of the selected block. Then, the selected block sense amplifier amplifies the data signal stored in the selected memory cell. Pairs of switching elements $S_{i0}$, $S_{i0}$; $S_{i1}$, $\overline{S}_{i1}$; ---; and $S_{ik}$, $\overline{S}_{ik}$ are inserted in the pairs of bit lines in the blocks $B_{i0}$, $B_{i1}$, --, $B_{ik}$, respectively, for connecting the blocks in series. Column decoder $CD_i$ is inserted between the block ($BK_{ik}$) which is nearest to the pair of bus lines DB, $\overline{DB}$, and the pair of bus lines DB, $\overline{DB}$. When the i-th column is selected by signal $Y_i$, transfer gates $Q_{i1}$ and $Q_{i2}$ provided in the column decoder $CD_i$ are set to the ON state for sending the data signal which is amplified by the selected block sense amplifier to the pair of bus lines DB, $\overline{DB}$.

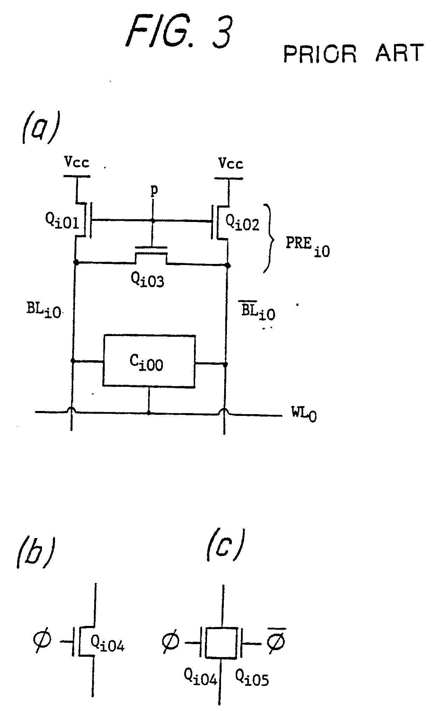

Further details of the block circuits and of their operation when the memory device is in the read mode will be explained referring to Figs. 3(a) to 3-(c) relating to block $BK_{i0}$.

Fig. 3(a) shows a pre-charge circuit $PRE_{i0}$ which comprises transistors $Q_{i01}$, $Q_{i02}$, and $Q_{i03}$ for applying equal pre-charging potential ($V_{cc} - V_{th}$) to the pair of bit lines $BL_{i0}$, $\overline{BL}_{i0}$ when a pre-charge signal p is applied to the gates of transistors $Q_{i01}$, $Q_{i02}$, and $Q_{i03}$. The transistor $Q_{i04}$ shown in Fig.3(b) forms the switching element $S_{i0}$ or $\overline{S}_{i0}$ shown in Fig. 2; transistor $Q_{i04}$ becomes ON when a clock signal $\phi$ is applied to its gate. Fig. 3(c) shows another type of switching element which consists of a transistor $Q_{i04}$ which is similar to that in Fig. 3(b) and of a transistor $Q_{i05}$ which is connected in parallel to transistor $Q_{i04}$ and is of a conduction type reverse to the one of transistor $Q_{i04}$; the switching element of Fig. 3(c) becomes ON when clock signals $\phi$, $\overline{\phi}$ are simultaneously applied to the gates of the transistors $Q_{i04}$ and $Q_{i05}$, respectively.

The operation of the circuit of Fig. 2 includes the following sequential steps: (1) one word line is selected by a word line select signal $X_0$, $X_1$, ---, or $X_n$ (see Fig. 1); for example, word $WL_0$ is selected by the word line select signal $X_0$; (2) one column is selected by a column select signal $Y_0$, $Y_1$, ---, or $Y_n$; for example, column i is selected by the column select signal $Y_i$; (3) the memory cell located at the cross point of the selected word line and column is selected; for example, memory cell $C_{i00}$ in block $BK_{i0}$ is selected; (4) one block select signal is provided when a word line and a column have been selected, corresponding to the block containing the selected cell; for example, block select signal $BS_{i0}$ is provided; (5) the block sense amplifier of the selected block is activated by the block select signal, so that a voltage difference appearing between the bit lines in the selected block is amplified; for example, block sense amplifier $SA_{i0}$ is activated by block select signal $BS_{i0}$, so that the voltage difference appearing between the bit lines $BL_{i0}$, $\overline{BL}_{i0}$ is amplified; (6) after the voltage difference has been amplified by the selected block sense amplifier, all the switching elements in the selected column are made ON so that all blocks of the selected column are connected in series; for example, after the voltage difference appearing between bit lines $BL_{i0}$, $\overline{BL}_{i0}$ has been amplified by block sense amplifier $SA_{i0}$, all the switching elements $S_{i0}$, $\overline{S}_{i0}$; $S_{i1}$, $\overline{S}_{i1}$; ---; and $S_{ik}$, $\overline{S}_{ik}$ are made ON so that all blocks $BK_{i0}$, $BK_{i1}$, ---, and $BK_{ik}$ are connected in series; and (7) the transfer gates in the column decoder belonging to the selected column are made ON by a column select signal for transferring the amplified data signal onto data bus DB, $\overline{DB}$ ; for example, the transfer gates $Q_{il}$, $\overline{Q}_{il}$ in column decoder $CD_i$ are made ON by the column select signal $Y_i$ for transferring the amplified data signal onto data bus DB, $\overline{DB}$ .

In the above step (6), it is not necessary that "all switching elements" be made ON. As already known, it is sufficient to set in the ON state the switching elements in the selected block and in the blocks located between the selected block and the column decoder $CD_i$.

In addition, also as already known, all other block sense amplifiers may be activated after the selected block sense amplifier has been activated and the switching elements have been made ON.

Thus, in the known memory device of Fig.2, the load capacitance for the sense amplifier can be kept small at the first time when the block sense amplifier in the selected block is activated. However, when the blocks located between the selected block and the column decoder $CD_i$ are serially connected by the closing of the switching elements, the load capacitance for the selected block sense amplifier increases; for example in Fig. 2, when block $BK_{i0}$ is selected and sense amplifier $SA_{i0}$ is activated and the switching elements serially connect all the blocks, the load capacitance becomes the total capacitance along the whole bit lines in column i. Accordingly, the sense amplifier in the farthest block from the data bus, for example sense amplifier $SA_{i0}$ in block $BK_{i0}$, must have a great enough driving ability to amplify the voltage difference in a short enough time. However, all the sense amplifiers have an equal driving ability, and if the sense amplifier in the nearest block from the data bus, for example sense amplifier $SA_{ik}$ in block $Bk_{ik}$, is selected, this sense amplifier ($SA_{ik}$) wastes too much power.

This drawback is eliminated according to the present invention by providing block sense amplifiers having different driving abilities.

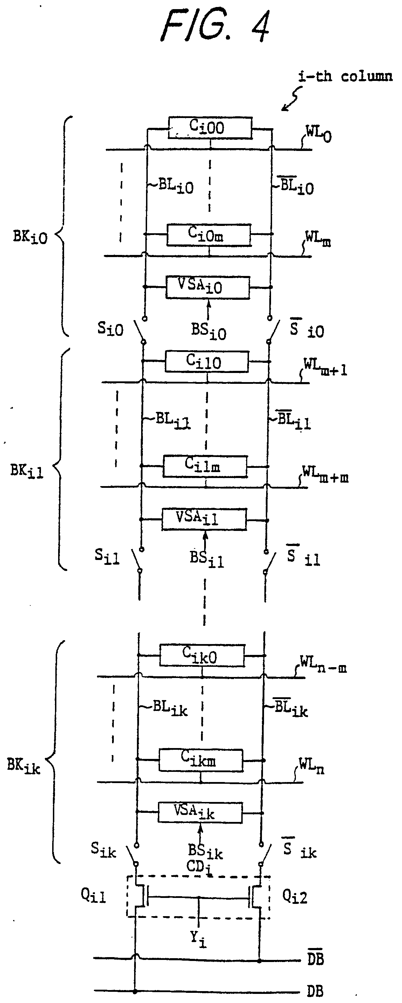

Fig. 4 is a block and circuit diagram of a column part of a memory device embodying the present invention. The block and circuit diagram in Fig.4 has the same constitution as that of the block and circuit diagram of Fig.2, and, in Figs. 2 and 4, the parts having the same reference symbols function equally. In Fig. 4, $VSA_{i0}$, $VSA_{il}$, ---, $VSA_{ik}$ designate the block sense amplifiers which are similar to the block sense amplifiers in Fig.2 but have individual driving abilities different from each other such that the block sense amplifier in the farthest block from column decoder $CD_i$ or data bus DB, $\overline{DB}$ has the maximum driving ability and the block sense amplifier in the block nearest to data bus DB, $\overline{DB}$ has the minimum driving ability.

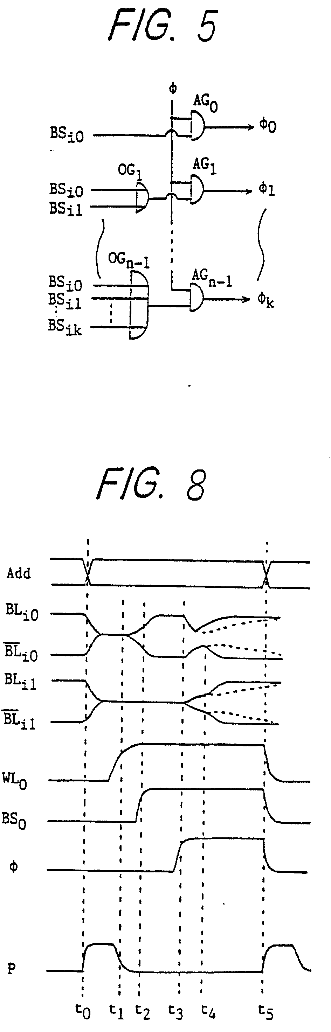

In Fig. 4, for example, when a data signal stored in memory cell $C_{il0}$ located in the i-th column and block $BK_{il}$ is read out, the memory device functions as follows. (1) the i-th column is selected when column select signal $Y_i$ is applied to column decoder $CD_i$ (see Fig. 1); (2) a word line $WL_{m+1}$ corresponding to memory cell $C_{il0}$ is selected and block select signal $BS_{il}$ is provided, so that sense amplifier $VSA_{il}$ is activated by block select signal $BS_{il}$, and the voltage difference appearing between bit lines $BL_{il}$, $\overline{BL}_{il}$ due to the data signal stored in memory cell $C_{il0}$ is amplified; and (3) the switching elements $S_{i1}$, $\overline{S}_{i1}$; $S_{i2}$, $\overline{S}_{i2}$; ---, and $S_{ik}$, $\overline{S}_{ik}$ in the selected block $BK_{i1}$ and in the blocks $BK_{i2}$, $BK_{i3}$, ---, and $BK_{ik}$ located between the selected block $BK_{i1}$ and the column decoder $CD_i$ are set to the ON state for connecting bit lines $BL_{i1}$, $\overline{BL}_{i1}$ to data bus DB, $\overline{DB}$ through column decoder $CD_i$. (Switching elements $S_{ik}$, $\overline{S}_{ik}$ in the block $BK_{ik}$ nearest to the data bus can be omitted because they are always used.) The above control of the switching elements is performed by modified clock signals generated by a modified clock signal generator such as the one shown in Fig. 5.

The modified clock signal generator shown in Fig. 5 generates modified clock signals $\phi_0$, $\phi_1$, ---, and $\phi_k$ for controlling the setting of the respective switching elements $S_{i0}$, $\overline{S}_{i0}$; $S_{i1}$, $\overline{S}_{i1}$; ---, and $S_{ik}$, $\overline{S}_{ik}$ to the ON or OFF state. The modified clock signals are similar to the clock signal $\phi$ shown in Figs. 3(a) and (b) but they control the switching elements as follows: all of the modified clock signals are required only when the farthest block (block $BK_{i0}$) from data bus DB, $\overline{DB}$ is selected; when a block nearer than block $BK_{i0}$ to the data bus is selected, modified clock signals for the blocks farther than the selected block from the data bus become unnecessary; for example, when block $BK_{i1}$ is selected, the modified clock signal $\phi_0$ for controlling the switching elements $S_{i0}$, $\overline{S}_{i0}$ in block $BK_{i0}$ is not necessary, and when block $BK_{ik}$ is selected, the clock signal $\phi_k$ only is necessary. The above selection of the modified clock signals is made in the modified clock signal generator by combining properly the block select signals $BS_{i0}$, $BS_{i1}$, ---, and $BS_{ik}$. In Fig. 5, OR gates $OG_1$, ---, $OG_k$ perform the above logic functions, and AND gates $AG_0$, $AG_1$, ---, and $AG_k$ produce the modified clock signals every time when clock signal $\phi$ is applied to said AND gates. The OR gate $OG_j$ has a plurality of inputs receiving respectively the block select signals $BS_{i0}$ to $BS_{ij}$ (j being an integer having any value from 1 to k). The AND gate $AG_0$ has two inputs receiving respectively the clock signals and the block select signal while the AND gate $AG_j$ has two inputs receiving respectively the clock signal $\phi$ and the output of the OR gate $OG_j$.

Thus, applying the modified clock signal generator to the memory device, the bit lines in the selected block and the blocks located between the selected block and the data bus can be connected.

Thus, the load capacitance of the activated sense amplifier can be reduced as much as possible; for example, when block $BK_{i1}$ is selected, the stray capacitance appearing along bit lines $BL_{i0}$, $\overline{BL}_{i0}$ in block $BK_{i0}$ has no influence upon sense amplifier $SA_{i0}$.

When the upper blocks, i.e. the blocks farther from the data bus than the selected block, are not used, the pre-charge circuits (or bit line reset circuits) of Fig. 3(a) in said upper blocks can be controlled to be non-operative, which also contributes to saving power consumption.

As hereinbefore explained, the sense amplifier in the selected block first operates, and then the switching elements in lower blocks, i. e. the blocks located between the selected block and the data bus are set to the ON state. Accordingly, when the pairs of bit lines in the lower blocks are connected to the pair of bit lines in the selected block, the voltage difference which has appeared between the bit lines in the selected block decreases due to the stray capacitance and the potential of the bit lines in the lower blocks, which causes the increase of the access time to the memory device. Accordingly, it can be said that the access time depends on the location of the selected block; for example, when the distance between the selected block and the data bus increases, the access time increases. The load capacitance for the sensing amplifier in the selected block is actually the sum of the stray capacitance of the lower blocks and the data bus. Therefore, when the sensing amplifier in each block has the same driving ability, as in the prior art, it becomes difficult for a sensing amplifier in a block placed far from the data bus to drive its load capacitance in a short access time. If the driving ability of the block which is the farthest from the data bus is made large enough to sufficiently shorten the access time, and if each sense amplifier must have the same large driving ability as the sense amplifier in the farthest block, this causes a waste of power when the sense amplifiers in the blocks located near the data bus are selected.

The present invention solves this problem by providing block sense amplifiers with different driving abilities as a function of their location with respect to the data bus, the farthest block from the data bus having the highest driving ability; for example, in Fig. 4, sense amplifier $VSA_{i0}$ has the maximum driving ability and the driving ability becomes smaller and smaller as the distance between the block and the data bus decreases. Then, the increase in the load capacitance can be compensated by the increase in the driving ability so that the access time for all the blocks can be equalized.

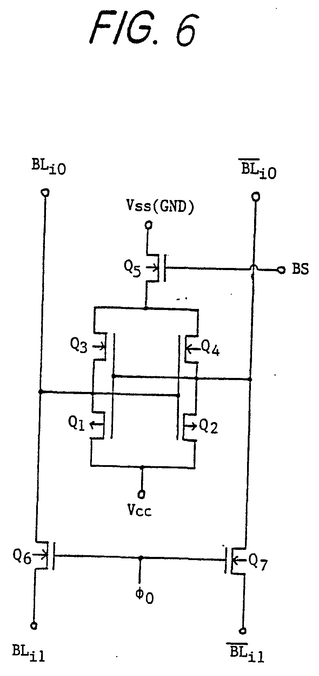

Fig. 6 shows a circuit diagram of a block sense amplifier with a pair of switching elements, for example in block $BK_{i0}$. $Q_1$ and $Q_2$ are p-channel MOS (Metal Oxide Semiconductor) transistors, while $O_3$, $Q_4$, and $Q_5$ are n-channel MOS transistors. $V_{SS}$ is a low power supply voltage (usually ground (GND)) and $V_{CC}$ is a high power supply voltage. BS is a block select terminal, and $BL_{i0}$, $\overline{BL}_{i0}$, $BL_{i1}$, $\overline{BL}_{i1}$; are divided bit lines as in Fig.2. Transistors $Q_1$ and $Q_3$, and transistors $Q_2$ and $Q_4$ compose two CMOS (Complementary MOS) inverters, respectively, and the two CMOS invertors intersect each other to form a flop-flop circuit. The circuit formed by the two parallel connected CMOS invertors is serially connected with transistor $Q_5$ between $V_{CC}$ and $V_{SS}$. Transistor $Q_5$ is set to the ON state upon reception of a block select signal on the terminal BS, activating the sense amplifier. $Q_6$ and $Q_7$ are n-channel MOS transistors which form the switching elements into the bit lines and similar to the ones shown in Fig.3(b).

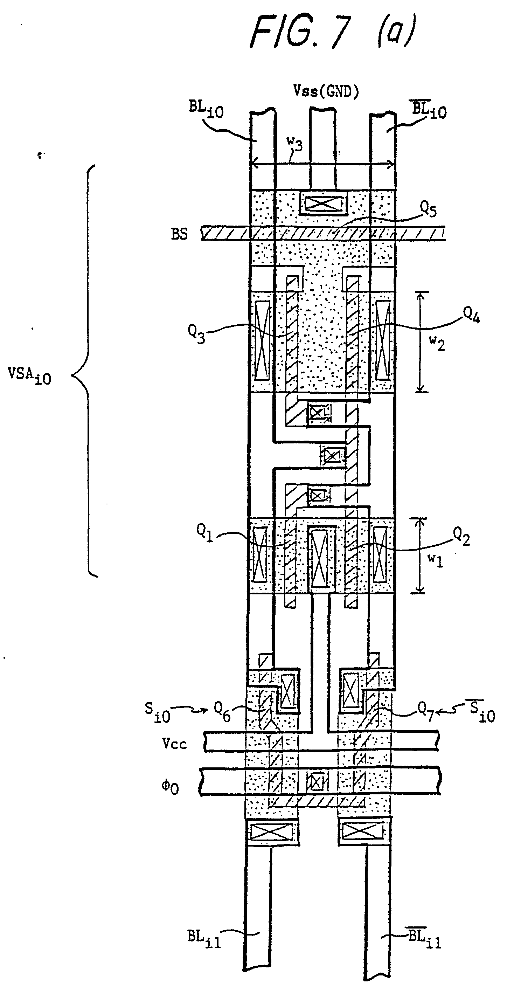

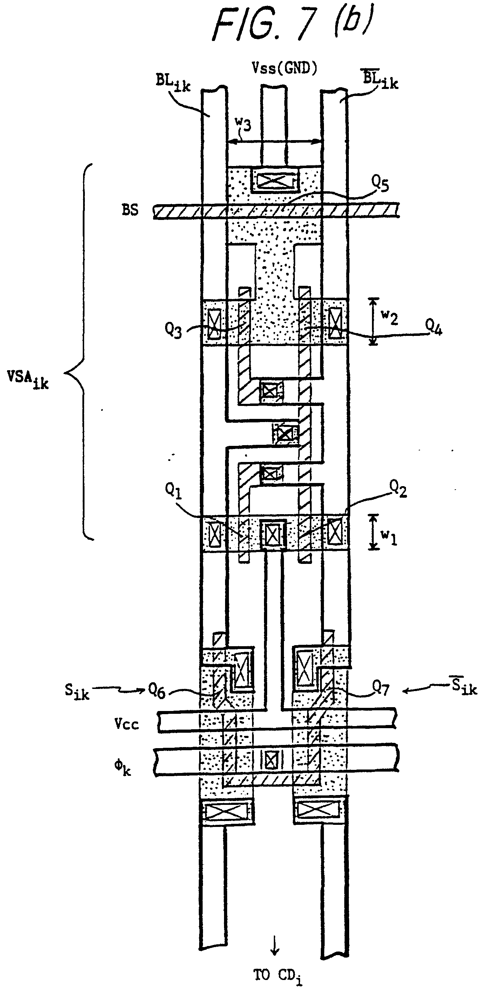

The differences in the driving ability of the block sense amplifiers can be obtained by changing the channel size of transistors $Q_1$, $Q_2$, $Q_3$, and $Q_4$. Figs. 7(a) and (b) show plan views of the IC (Integrated semiconductor Circuit) pattern for the circuit of Fig.6, respectively when the block sense amplifier has the maximum driving ability, and when the block sense amplifier has the minimum driving ability. In Figs. 7(a) and (b), each dotted area is a pattern for a limited diffusion zone, each shadowed area is a pattern for a gate material made of Poly-Silicon, each X marked portion shows a window for Al (Aluminum) contact, and each area enclosed by a thick line is a pattern for an Al wiring. In Figs. 7(a) and (b), $w_1$ is the channel size for transistors $Q_1$ and $Q_2$, $w_2$ is the channel size for transistors $Q_3$ and $Q_4$, and $w_3$ is the channel size for transistor $Q_5$. For example, when the memory device is in the class having M-bit memory capacity and the channel size for the transistors of a middle block sense amplifier, i.e. the block sense amplifier of the block located at the middle of the column, is set as a standard size, the ratio between each channel size and the respective standard size may be as follows: when the driving ability has its maximum value, $w_1$, $w_2$, and $w_3$ are longer than the respective standard sizes by as much as forty percent and when the driving ability has its minimum value, $w_1$, $w_2$, and $w_3$ are smaller than the respective standard sizes by sixty percent.

Fig.8 is a time chart illustrating the operation of the memory device shown in Fig. 4. When the amplitude of an address signal $A_{dd}$ changes at time $t_0$, a pre-charge signal p is generated so that all the pairs of bit lines $BL_{i0}$, $\overline{BL}_{i0}$; $BL_{i1}$, $\overline{BL}_{i1}$; ---; and $BL_{ik}$, $\overline{BL}_{ik}$ shown in Fig.4 are charged to an equal value, such as $V_{cc}$ - $V_{th}$ for example. Then, when word line $WL_0$ is selected (see Figs. 3 and 4) at

time $t_1$, memory cell $C_{i00}$ in the column i is selected, and a small voltage difference between bit lines $BL_{i0}$, $\overline{BL}_{i0}$ in block $BK_{i0}$ appears due to the data signal stored in memory cell $C_{i00}$. At time $t_2$, block select signal $BS_{i0}$ becomes high (H) thus activating sense amplifier $VSA_{10}$ (transistor $Q_5$ becomes ON in Fig.6) for amplifying the small voltage difference. After the voltage difference on bit lines $BL_{i0}$, $\overline{BL}_{i0}$ has been sufficiently amplified by sense amplifier $VSA_{i0}$, clock signals $\phi_0$, $\phi_1$, ---, and $\phi_k$ become high (H) at time $t_3$ and all switch elements $S_{i0}$, $\overline{S}_{i0}$; $S_{i1}$, $\overline{S}_{i1}$; ---, and $S_{ik}$, $\overline{S}_{ik}$ become ON (because the farthest block $BK_{i0}$ from the data bus is selected in this example).

In the above example, at the time immediately after all switch elements have been made ON, the potential on the bit lines in all other non-selected blocks is a middle value of the pre-charge potential; accordingly, the H side of the bit lines $BL_{i0}$, $\overline{BL}_{i0}$ in selected block $BK_{i0}$ decreases while the T thereof increases. However, since the driving ability of sense amplifier $VSA_{i0}$ is great, the voltage difference appearing on bit lines $BL_{i0}$, $\overline{BL}_{i0}$ (and also on the other bit lines in the non-selected blocks) rapidly returns back to the value it had just before $t_3$ though the load for sense amplifier $BSA_{i0}$ has the maximum value. The dotted lines in Fig. 8 represent the voltage differences on the bit lines in the prior art memory device of Fig.2, which shows the merits of the present invention. As a result, the time $t_5$ for changing the address signal Add can be hastened, which is effective to raise the operation speed of the memory device.

It could have been imagined to activate the sense amplifiers in the non-selected blocks, after the corresponding switching elements have been made ON, if the selected block is far from the data bus. However, the control of the sense amplifiers in the non-selected blocks would have become too complicated, whereas, in the memory device of the present invention, the control of the sense amplifiers can be simply realized.

It can be noted also that if all sense amplifiers were driven when the nearest block to the data bus is selected, this would result in a waste of power and in electrical noise because the amplification of the voltage difference would be made too quickly and the noise would produce a wrong operation of the memory device.

While the above description has been made with respect to a static RAM, it is quite apparent that the present invention can also be applied to a dynamic RAM.

## Claims

1. A semiconductor memory device having a plurality of memory cells arranged in a matrix formed by word lines and bit lines connected to a data bus (DB, $\overline{DB}$), and comprising: a plurality of blocks ($BK_{i0}$, ---, $BK_{ik}$) provided by dividing each bit line ($BL_i$, $\overline{BL}_i$) into divided bit lines ($BL_{ik}$, $\overline{BL}_{ik}$) and each including a plurality of memory cells ($C_{i00}$, ---, $C_{i0m}$; ---; $C_{ik0}$,--- ,$C_{ikm}$),a sense amplifier ($VSA_{i0}$, ---, $VSA_{im}$), and a switching element ($S_{i0}$, $S_{i0}$; ---; $S_{ik}$, $\overline{S}_{ik}$) connecting divided bit lines ($BL_{i0}$, $BL_{i1}$) means responsive to the selection of a memory cell to be accessed for activating only the sense amplifier of the block containing the selected memory cell; and means controlling the switching elements after activation of the sense amplifier of said selected block containing the selected memory cell, to make ON only the switching elements of the selected block and of each block eventually located between the selected block and the data bus, characterised in that the driving abilities of the sense amplifiers ($VSA_{i0}$, ---; $VSA_{in}$) are different from each other and increase as the distance between the corresponding blocks and the data bus increases.

2. A semiconductor memory device according to claim 1, characterized in that each sense amplifier comprises a plurality of MOS (Metal Oxide Semiconductor) transistors with a channel size which increases as the distance between the corresponding blocks and the data bus increases, whereby the transistors in the farthest block have the widest channel size to confer to the sense amplifier in said farthest block the highest driving ability whereas the transistors in the nearest block have the smallest channel size to confer to the sense amplifier in said nearest block the lowest driving ability.

## Revendications

1. Dispositif de mémorisation à semiconducteur possédant plusieurs cellules de mémoire disposées en une matrice qui est formée de lignes de mot et de lignes de bit connectées à un bus de données (DB, $\overline{DB}$), et comprenant : plusieurs blocs ($BK_{i0}$, ..., $BK_{ik}$) obtenus par division de chaque ligne de bit ($BL_i$, $\overline{BL}_i$) en lignes de bit divisées ($BL_{ik}$, $\overline{BL}_{ik}$), et comportant chacun plusieurs cellules de mémoire ($C_{i00}$, ..., $C_{i0m}$ ; ... $C_{ik0}$, ..., $C_{ikm}$), un amplificateur de lecture ($VSA_{i0}$, ..., $VSA_{im}$), et un élément de commutation $S_{i0}$, $\overline{S}_{i0}$; ...; $S_{ik}$, $\overline{S}_{ik}$) connectant des lignes de bit divisées ($BL_{i0}$,

BL$_{i1}$), des moyens qui, en réponse à la sélection d'une cellule de mémoire à laquelle il doit être fait accès, n'activent que l'amplificateur de lecture du bloc contenant la cellule de mémoire sélectionnée ; et des moyens commandant les éléments de commutation, après l'activation de l'amplificateur de lecture dudit bloc sélectionné contenant la cellule de mémoire sélectionnée, de façon à ne rendre conducteurs que les éléments de commutation du bloc sélectionné et de chaque bloc éventuellement placé entre le bloc sélectionné et le bus de données,
caractérisé en ce que les aptitudes d'excitation des amplificateurs de lecture (VSA$_{i0}$, ..., VSA$_{in}$) sont différentes les unes des autres et augmentent lorsque la distance entre les blocs correspondants et le bus de données augmente.

2. Dispositif de mémorisation à semiconducteur selon la revendication 1, caractérisé en ce que chaque amplificateur de lecture comprend plusieurs transistors MOS (métal-oxyde-semiconducteur) ayant une dimension de canal qui augmente lorsque la distance entre les blocs correspondants et le bus de données augmente, de sorte que les transistors se trouvant dans le bloc le plus éloigné ont la dimension de canal la plus large de façon à conférer à l'amplificateur de lecture dudit bloc le plus éloigné l'aptitude d'excitation la plus élevée, tandis que les transistors du bloc le plus rapproché possèdent la plus petite dimension de canal afin de conférer à l'amplificateur de lecture dudit bloc le plus rapproché l'aptitude d'excitation la plus basse.


## Ansprüche

1. Halbleiterspeichervorrichtung mit einer Vielzahl von Speicherzellen, die in einer Matrix angeordnet sind, welche durch Wortleitungen und Bitleitungen gebildet ist, die mit einem Datenbus (DB, $\overline{DB}$) verbunden sind, und mit:
einer Vielzahl von Blöcken (BK$_{i0}$, ---, BK$_{ik}$), die durch Unterteilen jeder Bitleitung (BL$_i$, $\overline{BL}_i$) in geteilte Bitleitungen (BL$_{ik}$, $\overline{BL}_{ik}$) gebildet sind und jeweils eine Vielzahl von Speicherzellen (C$_{i00}$, ---, C$_{i0m}$; ---; C$_{ik0}$, ---, C$_{ikm}$), einen Leseverstärker (VSA$_{i0}$, ---, VSA$_{im}$), und ein Schaltelement (S$_{i0}$, $\overline{S}_{i0}$; ---; S$_{ik}$, $\overline{S}_{ik}$) enthalten, welches geteilte Bitleitungen (BL$_{i0}$, BL$_{i1}$) verbindet, und Einrichtungen, die auf die Auswahl einer Speicherzelle ansprechen, damit zu ihnen durch Aktivieren lediglich des Leseverstärkers des Blockes zugegriffen werden kann, der die ausgewählte Speicherzelle enthält; und Einrichtungen, welche die Schaltelemente nach Aktivierung des Leseverstärkers des genannten ausgewählten Blockes steuern, der die ausgewählte Speicherzelle enthält, um nur die Schaltelemente des ausgewählten Blockes und von jedem Block, der gegebenenfalls zwischen dem ausgewählten Block und dem Datenbus angeordnet ist, auf EIN zu stellen, dadurch gekennzeichnet, daß die Treiberfähigkeiten des Leseverstärkers (VSA$_{i0}$, ---; VSA$_{in}$) voneinander verschieden sind und zunehmen, so wie der Abstand zwischen den entsprechenden Blökken und dem Datenbus zunimmt.

2. Halbleiterspeichervorrichtung nach Anspruch 1, dadurch gekennzeichnet, daß jeder Leseverstärker eine Vielzahl von MOS-(Metalloxidhalbleiter)-Transistoren mit einer Kanalgröße umfaßt, welche zunimmt, so wie der Abstand zwischen den entsprechenden Blökken und dem Datenbus zunimmt, wodurch die Transistoren in dem entferntesten Block die breiteste Kanalgröße haben, um dem Leseverstärker in dem entferntesten Block die höchste Treiberfähigkeit zu verleihen, wohingegen die Transistoren in dem nächsten Block die kleinste Kanalgröße haben, um dem Leseverstärker in dem nächsten Block die niedrigste Treiberfähigkeit zu verleihen.

# FIG. 1

PRIOR ART

# FIG. 2

PRIOR ART

# FIG. 3

PRIOR ART

(a)

(b)

(c)

# FIG. 4

i-th column

# FIG. 5

# FIG. 8

# FIG. 6

# FIG. 7 (a)

# FIG. 7 (b)